# EUROPEAN PATENT APPLICATION

(11) **EP 3 944 328 A1**
(43) Date of publication of application: **26.01.2022**
(21) Application number: 20187500.2
(22) Date of filing: 23.07.2020
(51) Int. Cl.: H01L 27/28, H01L 27/30, H01L 51/00, H01L 51/05, H01L 51/10, H01L 51/42, H01L 51/44, C08G 61/00, C08G 73/00

(54) **ORGANIC SEMICONDUCTOR LAYER WITH DUAL FUNCTIONALITY IN THIN FILM DEVICE AND MANUFACTURING METHOD THEREOF**

(71) Applicant: BASF SE, 67056 Ludwigshafen am Rhein (DE)
(72) Inventor: LIN, Wei Hsiang, 16342 Suwon-si, Gyeonggi-do (KR); WU, Anju, 16342 Suwon-si, Gyeonggi-do (KR); LEE, JunMin, 16342 Suwon-si, Gyeonggi-do (KR)
(74) Representative: BASF IP Association

(57) **Abstract**

The present invention provides a sensing pixel sensing pixel comprises at least two different electronic components, wherein at least one organic semiconductor layer is produced in the same process step with the same material in each component. The present invention also provides an organic sensor array comprising the abovementioned sensing pixel, and a method to produce the sensing pixel. The method for manufacturing the sensing pixel can be carried out in a simple way and provide sensing pixel with good performance.

## Description

### TECHNICAL FIELD

The present invention relates to an organic semiconductor, a sensor array comprising the same and the manufacturing method thereof. The sensing pixel comprises at least two different electronic components, wherein at least one organic semiconductor layer is produced in the same process step with the same material in each component.

### BACKGROUND ART

Conventional sensor arrays of different function are fabricated from inorganic material using vacuum and high temperature processes on silicon wafer or glass substrate. The resulting device is rigid, thick and expensive and used as camera chip, fingerprint sensor and x-ray sensor.

In order to provide cheap and flexible devices with large area, it is proposed to build organic sensor arrays on a plastic film. For example, organic thin film transistor (OTFT) and organic photodiode (OPD) may be used in combination in such a sensor array. Due to the low processing temperature of lower than 150°C, many cheap plastic films with suitable Tg can be used in the sensor array. Besides, the sensor arrays can be made by employing solution processes, which are much more cost-efficient than processes using vacuum.

Organic semiconductor layers are used in organic sensors to improve the performance. However, different types of organic sensors usually use different organic semiconductor layers, which makes the manufacturing method of organic sensor arrays expensive and time-consuming. Besides, changing deposition material too many times may increase the risk of contamination of surface on which material is to be deposited.

US 9929215B2 describes a method of forming image sensor circuits including organic photodiodes and organic thin film transistor. The organic photodiode is formed on top of the organic thin film transistor, rather than on the same substrate as the organic thin film transistor.

It is desired to provide organic sensor arrays which can be manufactured by simple and cheap method, while still having satisfactory performance.

### CONTENTS OF THE INVENTION

It is an object of the present invention to provide a sensing pixel which solves the above problem. The sensing pixel comprises at least two different electronic components, wherein at least one organic semiconductor layer is produced in the same process step with the same material in each component.

Another object of the present invention is to provide a sensor array comprising the abovementioned sensing pixel.

The present invention also provides a method for manufacturing the sensing pixel, comprising forming at least one organic semiconductor layer in the same process step with the same material in each component.

Since the same material is used at the same time to manufacture the at least one organic semiconductor layer, the method for manufacturing the sensing pixel can be simplified, while the organic semiconductor layer functions well in the sensing pixels. Moreover, contamination incurred by changing material in deposition method can be reduced.

### DESCRIPTION OF FIGURES

The present invention will be described with reference to the figures, which are not intended to limit the present invention.
Fig. 1 shows a diagram illustrating the structure of the sensing pixel according to the present invention.
Fig. 2 shows a schematic representation of the method for the manufacturing of the sensing pixel.
Fig. 3 shows the dark current level of the OPD component.

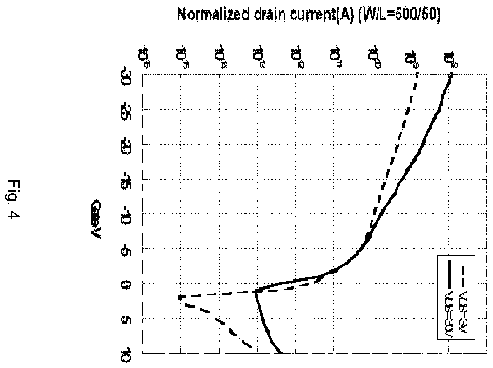

Fig. 4 shows the characteristics of the OTFT component.

### MODE OF CARRYING OUT THE INVENTION

Unless defined otherwise, all technical and scientific terms used herein have the meaning commonly understood by a person skilled in the art to which the invention belongs.

In one aspect, the invention provides a sensing pixel comprises at least two different electronic components, wherein at least one organic semiconductor layer is produced in the same process step with the same material in each component.

In one embodiment, the sensing pixel includes one or more OTFT components and a different electronic component, which may include but not limited to a thermistor component, a piezoelectric component, a gas/chemical adsorption component, an OPD component, etc.

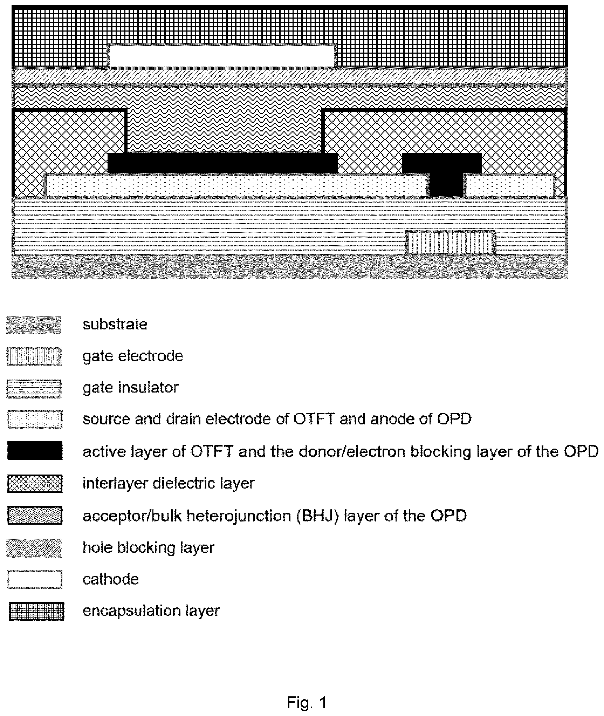

In one embodiment, the sensing pixel includes one or more OTFT components and an OPD component as the second electronic component. The OPD component is deposited on top of the OTFT component. A schematic illustration of the sensing pixel of the present invention is provided in Fig. 1. The OTFT component may have the same structure as that is well known to the skilled person in the art. For example, the OTFT component according to the present invention may have a first conductive layer deposited and patterned on top of the substrate as the gate electrode, a dielectric layer on top of the gate electrode as the gate insulation layer, and a second conductive layer deposited and patterned on top of the gate insulation layer, which serves as source/drain electrode, and as well as anode in OPD component. A first organic semiconductor layer ("FOS Layer") is deposited and patterned on top of a second conductive layer, which serve as hole transporting function in OTFT component, as well as donor/electron blocking layer in OPD component. A second dielectric layer deposited and patterned on top of the first organic semiconductor layer as interlayer dielectric layer in OTFT component.

The OTFT component may comprise other useful layers, for example a self-assembly monolayer (SAM) may be presented between the source and drain electrode and the FOS Layer. Such SAM may help increase the charge injection between electrodes and semiconducting materials

For the OTFT component, many known and frequently used materials may be applied. For example, material for the first conductive layer may include, but not limited to, Ag, Au, Al, Cu, Cr, Ni, Ti and Pt; the second conductive layer may include, but not limited to, ITO, AZO, FTO and silver. Materials for the dielectric layer may include, but not limited to, PMMA (polymethyl methacrylate), PS (polystyrene), PVC (polyvinyl chloride), PVP (polyvinyl phenol), PI (polyimide), P4VP (poly (4-vinly phenol)), epoxy resin and PVA (polyvinyl alcohol).

The OPD component may have the traditional anode/donor layer/acceptor layer/cathode structure. The OPD component is deposited on top of the OTFT component. For example, one of the second conductive layer in OTFT serves as the anode of the OPD, a first organic semiconductor layer ("FOS Layer") in OTFT is on top of the anode, a second semiconductor layer ("SOS Layer") is on top of the FOS Layer and the cathode layer is on top of the second semiconductor layer. A hole blocking layer may be present between the cathode and the SOS layer.

For the fabrication of the OPD component, many known materials may be used for the acceptor/bulk heterojunction (BHJ) layer, the conductive layer (the anode, the cathode) and the dielectric layer. For example, phenyl-C61-butyric acid methyl ester (PCBM) and P3HT may be used for the acceptor/bulk heterojunction (BHJ) layer. Al, Mg, Li, Al-Li and Mg can be used for the conductive layer and PMMA (polymethyl methacrylate), PS (polystyrene), PVC (polyvinyl chloride), PVP (polyvinyl phenol), PI (polyimide), P4VP (poly (4-vinly phenol)), epoxy resin and PVA (polyvinyl alcohol) can be used for the dielectric layer.

In one embodiment according to the present invention, the FOS Layer is deposited both on top of the source and drain electrode, which also serves as the anode for the OPD component, and on top of the insulation layer and between the source electrode and the drain electrode.

Preferably, the FOS Layer is formed from a composition which comprises an organic semiconducting polymer and a crosslinking agent, wherein the organic semiconducting polymer and the crosslinking agent can undergo crosslinking reaction under thermal and/or light exposure.

Preferably, the organic semiconducting polymer may be selected from the group consisting of thiophene-based conjugated polymer and diketo-pyrrole-pyrrole (DPP)-based conjugated polymer. More preferably, the organic semiconducting polymer comprises repeating units of the formula 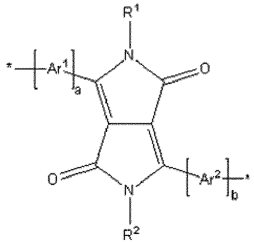
wherein R¹ and R² may be the same or different and are selected from hydrogen, a C₁₋₂₅-alkyl group, an alkenyl group, an alkynyl group, an allyl group, which can be substituted one to three times with C₁₋₄-alkyl; or a cycloalkyl group, which can be substituted one to three times with C₁₋₈-alkyl;
a and b are independently of each other an integral number in the range of 0 to 10, Ar¹ and Ar² in each case may be the same or different and independently of each other stand for a group of formula 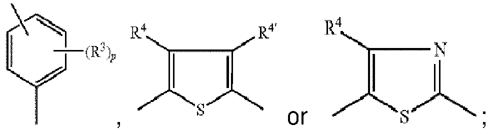
   p stands for 0, 1, 2, 3 or 4;
   R³ in each case may be the same or different and is selected from C₁₋₂₅-alkyl group or C₁₋₁₈-alkoxy; and
   R⁴ and R^{4'} independently from each other stand for hydrogen, C₁₋₂₅-alkyl group or C₁₋₁₈-alkoxy.

In a preferred embodiment, R¹ and R² may be the same or different and are selected from hydrogen, a C₁₋₂₅-alkyl group, an alkenyl group, an alkynyl group, or an allyl group, which can be substituted one to three times with C₁₋₄ alkyl. More preferably, R¹ and R² may be the same or different and are selected from hydrogen, or a C₁₋₂₅-alkyl group. Most preferably, R¹ and R² may be the same or different and stand for a C₅₋₂₅-alkyl group.

In another preferred embodiment, a and b are in the range of 0 to 6, preferably in the range of 1 to 3.

In another preferred embodiment, Ar¹ and Ar² in each case may be the same or different and independently of each other stand for a group of formula

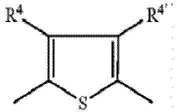

In another preferred embodiment, the organic semiconducting polymer may have the following structure: 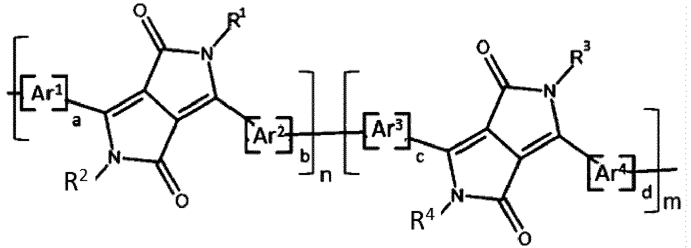
wherein R¹, R², R³ and R⁴ may be the same or different and are selected from hydrogen, a C₁₋₂₅-alkyl group, an alkenyl group, an alkynyl group, an allyl group, which can be substituted one to three times with C₁₋₄-alkyl; or a cycloalkyl group, which can be substituted one to three times with C₁₋₈-alkyl;
Ar¹, Ar², Ar³ and Ar⁴ in each case may be the same or different and independently of each other stand for a group of benzene, substituted benzene, thiophene and substituted thiophene;
a, b, c and d are independently of each other an integral number in the range of 0 to 10, preferably in the range of 1 to 5 and more preferably in the range of 1 to 3; and n is a number in the range of 0.05 to 0.95 and m is a number in the range of 0.95 to 0.05, preferably n is a number in the range of 0.1 to 0.9 and m is a number in the range of 0.9 to 0.1, and more preferably n is a number in the range of 0.15 to 0.85 and m is a number in the range of 0.85 to 0.15.

In another preferred embodiment, the organic semiconducting polymer has the following structure: 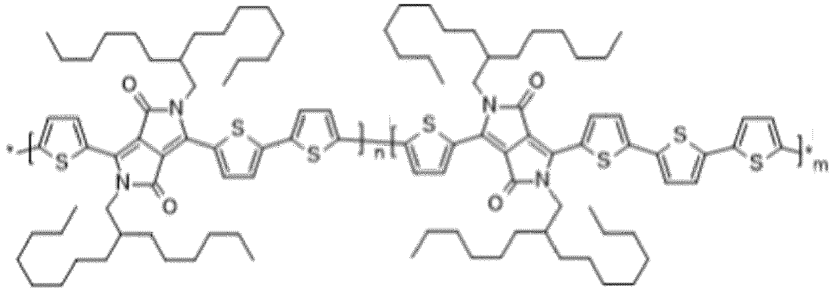 wherein n is a number in the range of 0.05 to 0.95 while m is a number in the range of 0.95 to 0.05. Preferably, n is a number in the range of 0.5 to 0.9 while m is a number in the range of 0.5 to 0.1. More preferably, n is a number in the range of 0.7 to 0.85 while m is a number in the range of 0.3 to 0.15.

Preferably, the crosslinking agent may be selected from the group consisting of diazirine, phenyl azide, fluoro-phenyl azide and acyl azide. Many bisazides may be used, such as 1,6-diazidohexane (DAZH), ethylene bis(4-azido-2,3,5-trifluoro-6isopropylbenzoate) (sFPA), 4,4'-bis(azidomethyl)-1,1'-biphenyl (BABP), 1,2-bis((4-(azidomethyl)phenethyl)thio)ethane (TBA-X), ethylene bis(4-azido-2,3,5,6-tetrafluorobenzoate) (Bis(PFBA)), 3,6-bis(5-(4,4"-bis(3-azidopropyl)-[1,1':3',1"-terphenyl)-5'-yl)thiophen-2-yl)-2,5-bis(2-ethylhexyl)-2,5-dihydropyrrolo(3,4-c)pyrrole-1,4-dione (DPPTPTA), 4-4'-bis(1-azido)undecane)dicyclopenta-(2,1-b:3,4-b')dithio-phene-bis(5-fluoro-7-(5'-hexyl-(2,2'-bithiophene)-5-yl)benzo-(c)(1,2,5)thiadiazole) N3-(CPDT(FBTTh2)2), bis(6-azidohexanoate)silicon phthalocyanine (HxN₃)2-SiPc), and tris(4-(5'-(3-azidopropyl)-2,2'- bithiophen5-yl)phenyl)amine (TPT-N₃). More preferably, the crosslinking agent is of formula

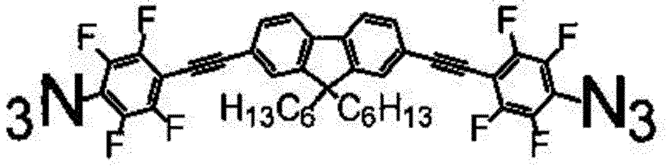

The crosslinking agent can be used in an amount of 0.5 to 10% by weight, preferably in an amount of 1 to 8% by weight, and more preferably in an amount of 2 to 5% by weight, based on the total weight of the composition.

The composition for forming the FOS Layer may optionally comprise an organic solvent. Suitable organic solvent may be selected from the group consisting of volatile organic solvent, such as toluene, xylene, mesitylene, etc.

The FOS Layer made from the above composition shows a good balance of electron blocking function and hole transport function, and thus can be used as electron blocking layer of OPD, donor layer of OPD, active layer of OTFT, hole transport layer of OLED, or organic semiconductor layer in piezo-resistive pressure sensor, chemical sensor or the like.

In a preferred embodiment, the sensing pixel consists of OPD and OTFT. The FOS Layer is used as the active layer of OTFT and the electron blocking layer and/or donor layer of OPD. In this case, the sensing pixel may have a structure comprising, in series from the bottom to the top:
a substrate;
a first conductive layer, which is used as the gate electrode of OTFT;
a first dielectric layer, which is used as the gate insulator of OTFT;
a second conductive layer, which is used as the source and drain electrode of OTFT and the anode of OPD;
a FOS Layer, which is used as the active layer of OTFT and the donor/electron blocking layer of OPD;
a second dielectric layer, which is used as interlayer dielectric layer.
a SOS Layer, which is used as the acceptor/bulk heterojunction layer of OPD;
a hole blocking layer between the SOS Layer and the third conductive layer;
a third conductive layer, which is used as the cathode of OPD, and a third dielectric layer, which is used as encapsulation layer.

The substrate may be formed by material selected from PEN (polyethylene naphthalate), PET (polyethylene terephthalate), PC (polycarbonate) and PI (polyimide).

The first conductive layer may be formed by material selected from Ag, Au, Al, Cu, Cr, Ni, Ti and Pt.

The first, second and third dielectric layers may be formed by material independently selected from PMMA (polymethyl methacrylate), PS (polystyrene), PVC (polyvinyl chloride), PVP (polyvinyl phenol), PI (polyimide), P4VP (poly (4-vinly phenol)), epoxy resin and PVA (polyvinyl alcohol).

The second conductive layer may be formed by material selected from, for example, ITO, IZO, FTO, ZnO, Ag and the like.

The FOS Layer is formed by the composition as described above. It may have a thickness in the range of 70 nm to 300 nm, preferably in the range of 80 nm to 250 nm, and more preferably in the range of 90 nm to 200 nm.

The second organic semiconductor layer may be formed by electron acceptor material, such as at least one of C60 and fullerene derivatives.

The third conductive layer may be formed from, for example, Al, Mg, Li, Al-Li, Mg-In and the like.

By using said FOS Layer in both OTFT and OPD of a sensor array, the OTFT may show mobility of about 0.01 cm²/Vs, and low off current <10⁻¹³A, turn on voltage < ±1V; and the OPD may show photo sensitivity of about 10 nA/cm²lux, and dark current < 1nA/cm² when reverse voltage = -1V.

In another aspect, the present invention provides an organic sensor array comprising the abovementioned semiconductors. The organic sensor array may comprise at least 4 sensing pixels, preferably at least 25 sensing pixels, more preferably at least 100 sensing pixels, and most preferably at least 400 sensing pixels. The sensing pixel may have a size in the range of 20 µm ^{∗} 20 µm to 100 µm ^{∗} 100 µm, preferably in the range of 30 µm ^{∗} 30 µm to 80 µm ^{∗} 80 µm and more preferably in the range of 40 µm ^{∗} 40 µm to 60 µm ^{∗} 60 µm. Many arrangement patterns know to the skilled person in the art may be applied. For example, the sensing pixels may be arranged in a Bayer mosaic pattern.

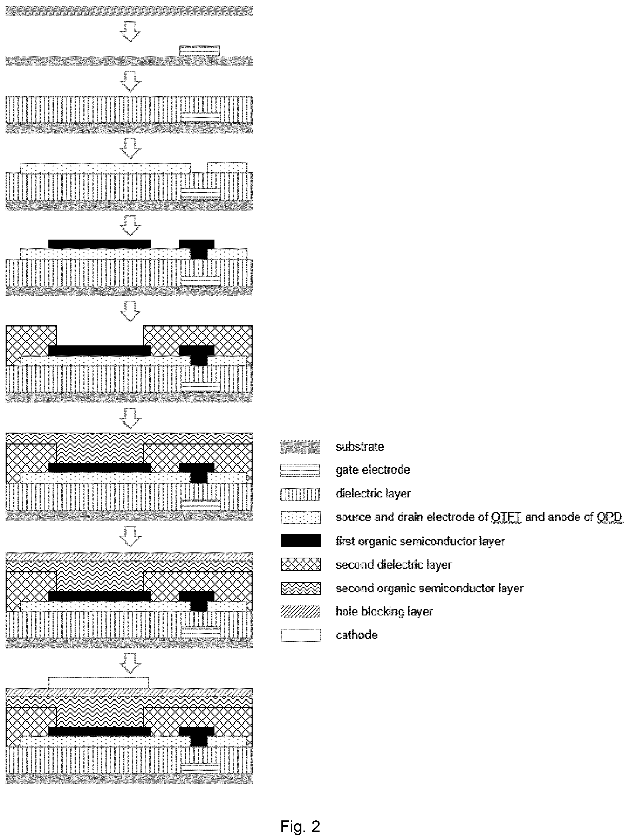

In a third aspect, the present invention provides a method to produce the sensing pixel. A schematic representation of the method is provided in Fig 2. The OTFT is fabricated first and the methods are well known to the skilled person in the art. For example, a first conductive layer is deposited on a substrate and patterned to form the gate electrode of OTFT device. On top of the first conductive layer, a first dielectric layer is deposited and patterned to form the gate insulator of OTFT device. On top of the first dielectric layer, a second conductive layer is deposited and patterned to form the source and drain electrode of OTFT and the anode of OPD device. On top of the second conductive layer, an FOS Layer is deposited and patterned to form the active layer of OTFT and the donor/electron blocking layer (EBL) layer of OPD device. On top of the FOS Layer, a second dielectric layer is deposited and patterned to form the interlayer dielectric layer of the OTFT device. The OTFT component may comprise other useful layers, for example a self-assembly monolayer (SAM) may be presented between the source and drain electrode and the FOS Layer. Such SAM may help increase the charge injection between electrodes and semiconducting materials.

Afterwards, normal methods for the fabrication of OPD device known to the skilled person may be applied. For example, on top of this FOS Layer, an SOS Layer is deposited and patterned to form the acceptor/bulk heterojunction (BHJ) layer of the OPD device. On top of the SOS layer, a third conductive layer is deposited and patterned to form the cathode of OPD device. Other useful layers may also be deposited. A hole blocking layer may be present between the cathode and the SOS layer.

The key of the invention is to fabricate the OPD device directly on the OTFT device and fabricate the FOS Layer in both OPD and OTFT with the same organic materials. The fabrication of the FOS Layer may be carried out by many techniques known to the skilled person in the art, for example, solution processing, spin coating, or liquid coating techniques. The FOS Layer may contain one or more organic materials which can function as electron donating material and as electron blocking material.

Preferably, the sensing pixel consists of OPD and OTFT, and the method comprises the following steps:
(a) forming a first conductive layer on a substrate;
(b) forming a first dielectric layer on the first conductive layer;
(c) forming a second conductive layer on the first dielectric layer;
(d) forming a first organic semiconductor layer on the second conductive layer;
(e) forming a second dielectric layer on the first organic semiconductor layer;
(f) forming a second organic semiconductor layer on the second dielectric layer;
(g) forming a hole blocking layer on the second organic semiconductor layer;
(h) forming a third conductive layer on the hole blocking layer, and
(i) forming a third dielectric layer on the third conductive layer.

Fig. 2 shows an example of manufacturing the sensing pixel according to the present invention.

The FOS Layer may be formed by direct patterning, photolithography process, ink-jet printing, flexo printing, gravure printing, offset printing, or other suitable processes known in the art.

The other layers may be formed by known processes in the art, such as depositing, printing, photolithography process and the like.

The present invention will now be described with reference to the following examples, which are not intended to limit the present invention.

### Example

### Starting materials:

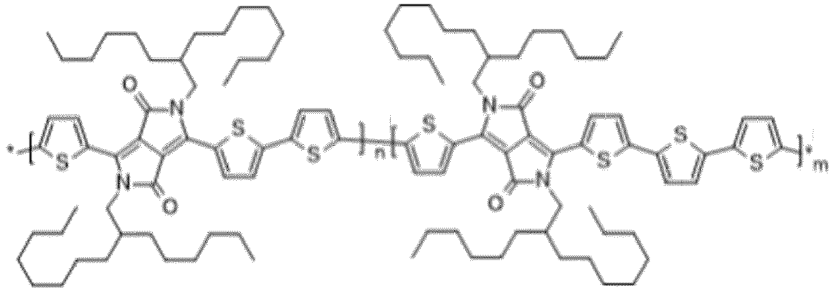

P3000, from BASF, wherein n=0.8, m=0.2 and the polymer has a weight average molecular weight of 50 kDa (measured by GPC against Polystyrene standard in THF). 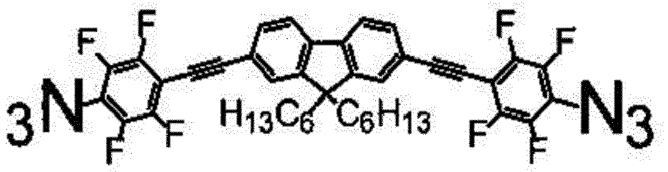 BAZI, from BASF.

FOS Layer material was made by mixing P3000 with BAZI, with the BAZI accounting for 3 wt%, based on the total weight of P3000 and BAZI.
PCBM, from Sigma-Aldrich
PEN substrate: 50nm, Q83-50 from Teijin film.
Gold: purchased from ITASCO.
Gate insulator: 4.5 % Polystyrene + 3 % crosslinking agent relative to PS.
ITO: ITO target purchased from AEO, Korea).
SU-8: purchased from MICRO CHEM.
Bathocuproine (hereinafter noted as "BCP"), from Sigma-Aldrich
Al: purchased from ITASCO.

### Test Methods:

Sensing pixel performance was determined by Keithley 4200 in atmosphere environment,
Condition: Vgs scan: +10 ∼ -30V; Vds with 2 steps: -3 & -30V

### Preparation of the composition and the organic semiconductor:

PEN substrate (50nm, Q83-50 from Teijin film) were prepared using UV glue (PHOTOBOND GB310 from DELO) to attached on glass substrate, and subjected to UV curing (365nm) for 1 minute.

Gold (purchased from ITASCO) were deposited as the first conductive layer using thermal evaporator deposition under deposition rate of 2A/sec (thickness: 50nm). The first conductive layer was patterned by standard photolithography process. Spin coating of photoresist (AZ-GXR601) was conducted on top of the first conductive layer with a spin speed of 4000rpm for 30 seconds to achieve 2µm thick film. Soft bake was conducted at 100°C for 2 minutes to remove solvent. To define the pattern of the first conductive layer, mask aligner and photo mask (designed by BASF) were used under 50mJ i-line intensity. Then developing was carried out under AZ 300MIF developer (purchased from sigma-aldrich) for 1 minute, followed by rinsing with DI water. The first conductive layer was etched by gold etchant (purchased from Transene company) for 30 seconds and then rinsed with DI water. Photoresist was removed by dipped in acetone for 1 minute. Then baking was carried out at 120°C for 5 minutes to remove moisture.

Gate insulator was deposited by spin coating with a spin speed of 1000rpm for 30 seconds to achieve 500nm film thickness. Soft bake was carried out at 90°C for 2 minutes to remove solvent. Gate insulator was then patterned by using mask aligner and photo mask (designed by BASF) under 20mJ i-line intensity, followed by developing under PGEMA for 1 minute. Then baking was carried out at 120°C for 15 minutes to remove solvent.

For fabricating the second conductive layer, ITO (ITO target purchased from AEO, Korea) was deposited using sputtering machine (thickness: 100nm). The second conductive layer was patterned by standard photolithography process. Spin coating of photoresist (AZ-GXR601) was carried out on top of the second conductive layer with a spin speed of 4000rpm for 30 seconds to achieve 2µm thick film. Soft bake was carried out at 100°C for 2 minutes to remove solvent. To define the pattern of the second conductive layer, mask aligner and photo mask (designed by BASF) were used under 50mJ i-line intensity. Then developing was conducted under AZ 300MIF developer (purchased from sigma-aldrich) for 1 minute, followed by rinsing with DI water. The second conductive layer was etched by ITO etchant (TE-100 purchased from Transene company) for 10 minutes and rinsed with DI water. Photoresist was removed by dipped in acetone for 1 minute. Then baking was conducted at 120°C for 5 minutes to remove moisture. Oxygen plasma (100W, 100sccm, 15 seconds) was applied to activate the electrode surface.

The first organic semiconductor layer material (FOS Layer material) was deposited by spin coating with a spin speed of 1000rpm for 30 seconds to achieve 100nm film thickness. Baking was carried out at 90°C for 2 minutes to remove solvent. The first organic semiconductor layer was patterned by using mask aligner and photo mask (designed by BASF) under 250mJ i-line intensity, followed by developing under xylene for 1 minute. Baking was carried out at 90°C for 15 minutes to achieve fully crosslinking.

Interlayer dielectric material (SU-8 purchased from MICRO CHEM) was deposited by spin coating with a spin speed of 6000rpm for 30 seconds to achieve 1.5µm film thickness to form the second dielectric layer. Baking was carried out at 95°C for 2 minutes to remove solvent. Interlayer dielectric layer was patterned by using mask aligner and photo mask (mask design by BASF) under 500mJ i-line intensity to define pattern, and post bake under 95°C for 2 minutes. Followed by developing under PGMEA for 1 minute. Baking 90°C for 15 minutes to fully crosslink.

Material for fabricating the SOS Layer OPD active layer was prepared by dissolving P3000 and PCBM with 1:1 ratio in xylene. The resulted OPD active layer material contains 1 wt% P3000 and 1 wt% PCBM. The OPD active layer material was applied using a spin coater at a speed of 400 rpm for 30 seconds, followed by soft baking at 90 °C for 2 minutes and thermal annealing at 120 °C for 20 minutes. The active layer had a thickness of 100 nm.

Hole blocking layer (BCP) was then applied by spin coating at a speed of 1000 rpm for 30 seconds on top of the active layer. The hole blocking layer has a thickness less than 10 nm.

The third conductive layer (Al, purchased from ITASCO) was deposited through thermal evaporation and the third electrode had a thickness of 100 nm.

Encapsulation material (SU-8 purchased from MICRO CHEM) was deposited by spin coating with a spin speed of 6000rpm for 30 seconds to achieve 1.5µm film thickness to form the second dielectric layer. Baking was carried out at 95°C for 2 minutes to remove solvent. Encapsulation layer was patterned by using mask aligner and photo mask (mask design by BASF) under 500mJ i-line intensity to define pattern, and post bake under 95°C for 2 minutes. Followed by developing under PGMEA for 1 minute. Baking 90°C for 15 minutes to fully crosslink.

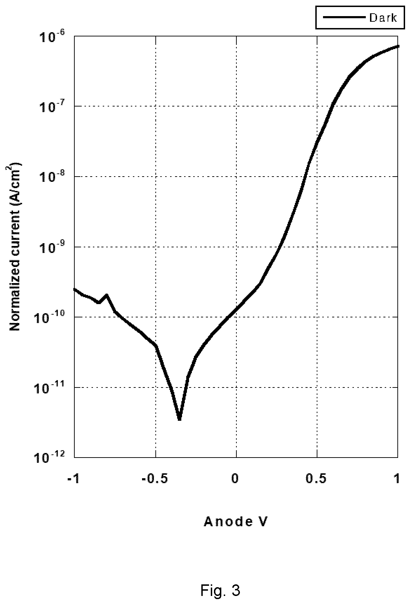

The performance of the semiconductor is presented in Fig. 3. The semiconductor shows a dark current of 2.5^{∗}10⁻¹⁰ A with a potential of -1 V at the anode, indicating that it has very low dark current level. The OTFT show an off current of 1^{∗}10⁻¹⁶ A at Vgs = -2 V and Vds=-3 V, and on/off ratio > 10⁶ at Vds = -3 V, indicating a good function of turn on and turn off a sensing pixel.

## Claims

1. A sensing pixel comprising at least two different electronic components, wherein at least one organic semiconductor layer is produced in the same process step with the same material in each component.

2. The sensing pixel according to claim 1, wherein at least one organic semiconductor layer is formed from a composition which comprises an organic semiconducting polymer and a crosslinking agent, and the organic semiconducting polymer and the crosslinking agent can undergo crosslinking reaction under thermal and/or light exposure.

3. The sensing pixel according to claim 2, wherein the organic semiconducting polymer is selected from the group consisting of thiophene-based conjugated polymer and diketo-pyrrole-pyrrole (DPP)-based conjugated polymer.

4. The sensing pixel according to claim 2, wherein the organic semiconducting polymer comprises repeating units of the formula 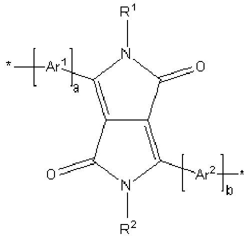
wherein R¹ and R² may be the same or different and are selected from hydrogen, a C₁₋₂₅-alkyl group, an alkenyl group, an alkynyl group, an allyl group, which can be substituted one to three times with C₁₋₄-alkyl; or a cycloalkyl group, which can be substituted one to three times with C₁₋₈-alkyl;
a and b are independently of each other an integral number in the range of 0 to 10, Ar¹ and Ar² in each case may be the same or different and independently of each other stand for a group of formula 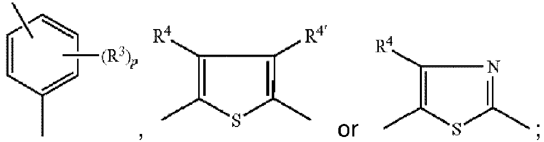
p stands for 0, 1, 2, 3 or 4;
R³ in each case may be the same or different and is selected from C₁₋₂₅-alkyl group or C₁₋₁₈-alkoxy; and
R⁴ and R^{4'} independently from each other stand for hydrogen, C₁-C₂₅ alkyl group or C1-C18 alkoxy.

5. The sensing pixel according to claim 2, wherein the organic semiconducting polymer have the following structure: 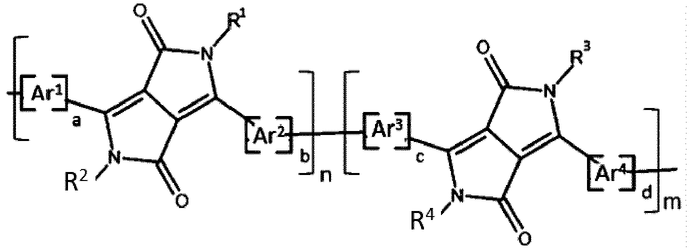
wherein R¹, R², R³ and R⁴ may be the same or different and are selected from hydrogen, a C₁₋₂₅-alkyl group, an alkenyl group, an alkynyl group, an allyl group, which can be substituted one to three times with C₁₋₄-alkyl; or a cycloalkyl group, which can be substituted one to three times with C₁₋₈-alkyl;
Ar¹, Ar², Ar³ and Ar⁴ in each case may be the same or different and independently of each other stand for a group of benzene, substituted benzene, thiophene and substituted thiophene;
a, b, c and d are independently of each other an integral number in the range of 0 to 10, preferably in the range of 1 to 5 and more preferably in the range of 1 to 3; and
n is a number in the range of 0.05 to 0.95 and m is a number in the range of 0.95 to 0.05, preferably n is a number in the range of 0.1 to 0.9 and m is a number in the range of 0.9 to 0.1, and more preferably n is a number in the range of 0.15 to 0.85 and m is a number in the range of 0.85 to 0.15.

6. The sensing pixel according to claim 2, wherein the organic semiconducting polymer has the following structure: 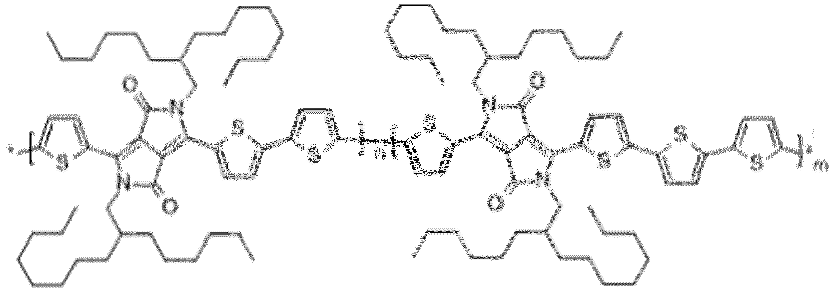 wherein n is a number in the range of 0.05 to 0.95 while m is a number in the range of 0.95 to 0.05; preferably, n is a number in the range of 0.5 to 0.9 while m is a number in the range of 0.5 to 0.1; more preferably, n is a number in the range of 0.7 to 0.85 while m is a number in the range of 0.3 to 0.15.

7. The sensing pixel according to claim 6, wherein n=0.8 and m=0.2.

8. The sensing pixel according to claim 2, wherein the crosslinking agent is selected from the group consisting of diazirine, phenyl azide, fluoro-phenyl azide and acyl azide.

9. The sensing pixel according to claim 2, wherein the crosslinking agent is of formula.

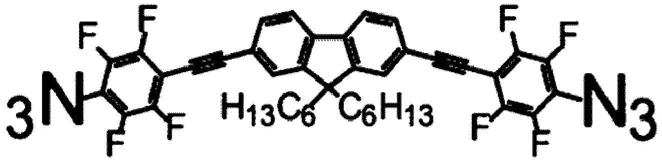

10. The sensing pixel according to claim 2, wherein the crosslinking agent is in an amount of 0.5 to 10% by weight, preferably in an amount of 1 to 8% by weight, and more preferably in an amount of 2 to 5% by weight, based on the total weight of the composition.

11. The sensing pixel according to claim 2, which comprises one or more OTFT component and a different electronic component, which may include but not limited to a thermistor component, a piezoelectric component, a gas/chemical adsorption component, an OPD component.

12. An organic sensor array comprising semiconductors according to any of the preceding claim.

13. The organic sensor array according to claim 12, which comprises at least 4 sensing pixels, preferably at least 25 sensing pixels, more preferably at least 100 sensing pixels, and most preferably at least 400 sensing pixels; and the sensing pixel sensing pixel may have a size in the range of 20 µm ^{∗} 20 µm to 100 µm ^{∗} 100 µm, preferably in the range of 30 µm ^{∗} 30 µm to 80 µm ^{∗} 80 µm and more preferably in the range of 40 µm ^{∗} 40 µm to 60 µm ^{∗} 60 µm.

14. A method for manufacturing a sensing pixel comprising at least two different electronic components, wherein at least one organic semiconductor layer is produced in the same process step with the same material in each component.

15. The method according to claim 14, wherein the sensing pixel consists of OPD and OTFT, and the method comprises the following steps:
(a) forming a first conductive layer on a substrate;
(b) forming a first dielectric layer on the first conductive layer;
(c) forming a second conductive layer on the first dielectric layer;
(d) forming a first organic semiconductor layer on the second conductive layer;
(e) forming a second dielectric layer on the first organic semiconductor layer;
(f) forming a second organic semiconductor layer on the second dielectric layer;
(g) forming a hole blocking layer on the second organic semiconductor layer;
(h) forming a third conductive layer on the hole blocking layer, and
(i) forming a third dielectric layer on the third conductive layer.
